# EUROPEAN PATENT APPLICATION

(11) **EP 4 839 054 A1**
(43) Date of publication of application: **11.11.2026**
(21) Application number: 25216672.3
(22) Date of filing: 18.11.2025
(51) Int. Cl.: H10F 19/90

(54) **BACK CONTACT SOLAR CELL AND PHOTOVOLTAIC MODULE**

(30) Priority: 08.05.2025 CN 202510586465
(71) Applicant: Jinko Solar (Haining) Co., Ltd., Haining City, Zhejiang (CN)
(72) Inventor: QIU, Lifeng, Haining City, Zhejiang Province (CN); YANG, Jie, Haining City, Zhejiang Province (CN); XIA, Zhipeng, Haining City, Zhejiang Province (CN); HUANG, Jide, Haining City, Zhejiang Province (CN); LIU, Changming, Haining City, Zhejiang Province (CN); ZHANG, Xinyu, Haining City, Zhejiang Province (CN); JIN, Hao, Haining City, Zhejiang Province (CN)
(74) Representative: Balder IP Law, S.L.

(57) **Abstract**

A back contact solar cell includes: a cell substrate divided into soldering regions arranged along a first direction; fingers arranged on the cell substrate along a second direction; solder pads arranged in the soldering regions and in edge portions of the substrate, wherein a respective solder pad of the solder pads is in contact with at least two adjacent fingers of a same polarity; solder joints arranged in the soldering regions and in a central portion of the substrate surrounded by the edge portions, wherein a respective solder joint is in contact with a respective finger; and connection lines extending along the second direction for connecting the solder joints to the solder pads.

## Description

### TECHNICAL FIELD

The present disclosure relates to the field of photovoltaics, and in particular, to a back contact solar cell and a photovoltaic module.

### BACKGROUND

As the fossil energy sources are depleting, solar cells have been increasingly used as an alternative source of renewable energy. A solar cell is a device that converts solar energy into electrical energy. The solar cell generates charge carriers based on the photoelectric effect, and the carriers are extracted through grid lines to facilitate effective utilization of the generated electrical energy. The grid lines of the solar cell play an important role in collecting and transmitting electrons. When multiple solar cells are assembled into a photovoltaic module, solder pads and/or solder joints are usually provided on the grid lines. Subsequently, tabbing ribbons electrically contact the solder pads and/or solder joints, thereby electrically connecting the grid lines of adjacent solar cells.

To further reduce the shading of grid lines on the front surfaces of solar cells, research on interdigitated back contact (IBC) solar cells has been increasingly advanced.

However, in IBC cells, during the process of electrically connecting tabbing ribbons to solder pads and/or solder joints, the starting and ending portions of the tabbing ribbon on a single back contact solar cell are subject to significant influence from solder paste distribution and mechanical stress applied by the tabbing ribbon. This often results in unstable electrical connections between the starting and ending portions of the tabbing ribbon and the grid lines, thereby reducing the photoelectric conversion efficiency of the back contact solar cell. Accordingly, there remains a need for a more suitable configuration to the photoelectric conversion efficiency of back contact solar cells.

### SUMMARY

The embodiments of the present disclosure provide a back contact solar cell and a photovoltaic module, which are at least advantageous for improving the photoelectric conversion efficiency of the back contact solar cell.

A back contact solar cell is provided according to one aspect of embodiments of the present application. The back contact solar cell includes: a cell substrate divided into soldering regions arranged along a first direction; fingers arranged on the cell substrate along a second direction; solder pads arranged in the soldering regions and in edge portions of the substrate, wherein a respective solder pad of the solder pads is in contact with at least two adjacent fingers of a same polarity; solder joints arranged in the soldering regions and in a central portion of the substrate surrounded by the edge portions, wherein a respective solder joint is in contact with a respective finger; and connection lines, extending along the second direction for connecting the solder joints to the solder pads.

In some embodiments, a subset of connection lines is in contact with a respective solder pad of the solder pads, each being in contact with at least one solder joint adjacent to the respective solder pad.

In some embodiments, at least one connection line comprises a first end adjacent to the solder pad and a second end adjacent to the solder joint, and a width of the first end is greater than a width of the second end along the first direction.

In some embodiments, at least one connection line comprises a first end adjacent to the solder pad and a second end adjacent to the solder joint, and a width of the first end is greater than a width of the second end along the first direction.

In some embodiments, the back contact solar cell further includes a current collecting portion, located on a side of the solder pad facing away from the solder joint and in the soldering region. A single current collecting portion is in contact with a plurality of fingers of the same polarity.

In some embodiments, the number of fingers of the same polarity in contact with the single current collecting portion is greater than the number of fingers of the same polarity in contact with the single solder pad.

In some embodiments, the connection line is shorter than the current collecting portion along the second direction; and/or, a cross section of the connection line is smaller than a cross section of the current collecting portion along a section perpendicular to the second direction.

In some embodiments, at least one connection line has a first cross-sectional area along a section perpendicular to the second direction, at least one finger has a second cross-sectional area along a section perpendicular to the first direction, and the first cross-sectional area is greater than the second cross-sectional area.

In some embodiments, an orthographic projection of the solder pad on the cell substrate is greater than an orthographic projection of the solder joint on the cell substrate; and/or a thickness of the solder pad is smaller than a thickness of the solder joint along a third direction.

In some embodiments, the number of solder joints in contact with the connection line differs among different soldering regions.

A photovoltaic module is provided according to another aspect of embodiments of the present application. The photovoltaic module includes: a solar cell string formed by connecting a plurality of back contact solar cells as described above, or formed by connecting a plurality of back contact solar cells manufactured by the method as described above; an encapsulant, configured to cover a surface of the solar cell string; and a cover plate, configured to cover a surface of the encapsulant facing away from the solar cell string.

The technical solution in the embodiments of the present disclosure offers at least the following advantages.

The solder pads and solder joints located in the same soldering region are positioned in the edge portion and in the central portion of the substrate, respectively. The solder pad can be regarded as the starting or ending soldering position when a tabbing ribbon subsequently makes electrical contact with the back contact solar cell. On this basis, each solder pad is designed to electrically connect with at least two adjacent fingers of the same polarity, while each solder joint electrically connects with a single finger. On one hand, this arrangement helps enhance the current collection efficiency of the solder pad, allowing the current from more fingers of the same polarity to be transmitted to the solder pad more quickly, thereby establishing a denser current collection network. This reduces the transmission distance of photogenerated carriers and lowers the series resistance of the back contact solar cell. On the other hand, as the starting or ending soldering position of a subsequent tabbing ribbon, the solder pad connecting more fingers of the same polarity can be designed with a larger size. This not only reduces the transmission resistance of the solder pad to accommodate to more fingers of the same polarity but also improves the alignment accuracy and connection strength between the solder pad and the tabbing ribbon, preventing issues such as cold soldering or detachment caused by excessive pressure from the tabbing ribbon on the solder pad. This contributes to improving the current collection efficiency of the solder pad and enhances the connection stability between the tabbing ribbon and the solder pad. In summary, these measures help increase the current collection efficiency and the photoelectric conversion efficiency of the back contact solar cell.

Further, the solder pad and at least one solder joint adjacent to the solder pad along the second direction can be electrically connected through the connection line. In other words, the connection line can electrically connect solder joints near the solder pad that are prone to cold soldering, missed soldering, or detachment to the solder pad. Even if these nearby solder joints do not make good contact with the tabbing ribbon and cannot transmit current to the tabbing ribbon, the connection line allows the current to be transmitted directly to the solder pad and then to the tabbing ribbon. The connection line thus further ensures that the subsequent tabbing ribbon can collect current from all fingers of the same polarity, thereby further improving the photoelectric conversion efficiency of the back contact solar cell.

### BRIEF DESCRIPTION OF THE DRAWINGS

One or more embodiments are illustrated by way of Figures in the drawings. These illustrations do not constitute a limitation of the embodiments, unless explicitly stated otherwise, and the drawings are not drawn to scale. For the purpose of more clearly describing the technical solution of the embodiments of the present disclosure or conventional techniques, a brief introduction of the drawings used in the embodiments is provided below. It is apparent that the drawings described below are merely some embodiments of the present disclosure, and those skilled in the art can obtain other drawings based on these drawings without exercising inventive skill.
FIG. 1 is a first partial top view of a back contact solar cell according to an embodiment of the present disclosure;
FIG. 2 is a second partial top view of the back contact solar cell according to an embodiment of the present disclosure;
FIG. 3 is a first partially enlarged top view of the back contact solar cell according to an embodiment of the present disclosure;
FIG. 4 is a second partially enlarged top view of the back contact solar cell according to an embodiment of the present disclosure;
FIG. 5 is a third partially enlarged top view of the back contact solar cell according to an embodiment of the present disclosure;
FIG. 6 is a fourth partially enlarged top view of the back contact solar cell according to an embodiment of the present disclosure;
FIG. 7 is a partial cross-sectional diagram of the back contact solar cell shown in FIG. 6 taken along a first section line AA1;
FIG. 8 is a partial perspective diagram of a photovoltaic module according to another embodiment of the present disclosure; and
FIG. 9 is a partial cross-sectional schematic diagram of the photovoltaic module shown in FIG. 8 taken along a second section line BB1.

### Reference numerals:

| | | | |
|---|---|---|---|
| 100, | cell substrate; | 101, | soldering region; |
| 111, | first soldering region; | 121, | second soldering region; |
| 102, | edge portion; | 103, | central portion; |
| 104, | fingers of a same polarity; | 114, | first finger; |
| 124, | second finger; | 105, | solder pad; |
| 106, | solder joint; | 107, | connection line; |
| 117, | first end; | 127, | second end; |
| 108, | current collecting portion; | 118, | third end; |
| 128, | fourth end; | 109, | edge portion; |
| 40, | back contact solar cell; | 41, | encapsulant; |
| 42, | cover plate; | 43, | tabbing ribbon. |

### DETAILED DESCRIPTION OF THE EMBODIMENTS

From the BACKGROUND, it is evident that the current collection efficiency of back contact solar cells needs improvement.

The embodiments of the present disclosure provide a back contact solar cell and a photovoltaic module. In the back contact solar cell, the solder pads and solder joints located in the same soldering region are positioned in the edge portion and the central portion, respectively. The solder pad can be regarded as the starting or ending soldering position when a tabbing ribbon subsequently makes electrical contact with the back contact solar cell. On this basis, each solder pad is designed to electrically connect with at least two adjacent fingers, while each solder joint electrically connects with a single finger. On one hand, this arrangement helps enhance the current collection efficiency of the solder pad, allowing the current from more fingers of the same polarity to be transmitted to the solder pad more quickly, thereby establishing a denser current collection network. This reduces the transmission distance of photogenerated carriers and lowers the series resistance of the back contact solar cell. On the other hand, as the starting or ending soldering position of a subsequent tabbing ribbon, the solder pad connecting more fingers of the same polarity can be designed with a larger size. This not only reduces the transmission resistance of the solder pad to accommodate to more fingers of the same polarity but also improves the alignment accuracy and connection strength between the solder pad and the tabbing ribbon, preventing issues such as cold soldering or solder detachment caused by excessive pressure from the tabbing ribbon on the solder pad. This contributes to improving the current collection efficiency of the solder pad and enhances the connection stability between the tabbing ribbon and the solder pad. In summary, these measures help increase the current collection efficiency and the photoelectric conversion efficiency of the back contact solar cell. Further, the solder pad and at least one solder joint adjacent to the solder pad along the second direction can be electrically connected through the connection line. In other words, the connection line can electrically connect solder joints near the solder pad that are prone to cold soldering, missed soldering, or detachment to the solder pad. Even if these nearby solder joints do not make good contact with the tabbing ribbon and cannot transmit current to the tabbing ribbon, the connection line allows the current to be transmitted directly to the solder pad and then to the tabbing ribbon. The connection line thus further ensures that the subsequent tabbing ribbon can collect current from all fingers of the same polarity, thereby further improving the photoelectric conversion efficiency of the back contact solar cell.

In the description of the embodiments of the present disclosure, the technical terms "first," "second," and the like are merely used to distinguish between different elements or features and should not be construed as indicating or implying relative importance, specific sequence, quantity, or hierarchical relationship of the features being referred to. In the description of the embodiments of the present disclosure, the term "plurality" means two or more, unless explicitly defined otherwise.

The term "embodiment" herein means that a specific feature, structure, or characteristic described in connection with the embodiment may be included in at least one embodiment of the present disclosure. The phrase "in an embodiment" appearing in various places throughout this specification does not necessarily refer to the same embodiment, nor does it mean that the embodiments are mutually exclusive or alternative to one another. Those skilled in the art should understand that the embodiments described herein can be combined with other embodiments.

In the description of the embodiments of the present disclosure, the term "and/or" is merely intended to describe an association relationship between the associated objects, meaning that three possible relationships may exist. For example, "A and/or B" may indicate: the existence of A alone, the coexistence of A and B, or the existence of B alone. In addition, the symbol "/" generally indicates an "or" relationship between the associated objects.

In the description of the embodiments of the present disclosure, the term "plurality" refers to two or more (including two). Similarly, "multiple groups" refers to two or more (including two) groups, and "multiple pieces" refers to two or more (including two) pieces.

In the description of the embodiments of the present disclosure, the technical terms such as "center," "longitudinal," "lateral," "length," "width," "thickness," "upper," "lower," "front," "rear," "left," "right," "vertical," "horizontal," "top," "bottom," "inner," "outer," "clockwise," "counterclockwise," "axial," "radial," and "circumferential," and the like, are used to describe positional or directional relationships based on the orientations or positions illustrated in the drawings. These expressions are intended solely for facilitating the description and simplification of the embodiments of the present disclosure and are not intended to indicate or imply that the referenced devices or elements must have a specific orientation, structure, or mode of operation. Therefore, such terminology should not be construed as limiting the embodiments of the present disclosure.

In the description of the embodiments of the present disclosure, unless explicitly stated otherwise, the technical terms such as "mounted," "connected," "coupled," and "fixed" should be understood in a broad sense. For example, the connection may be a fixed connection or a detachable connection, or may be formed integrally, a mechanical connection or an electrical connection, a direct connection or an indirect connection through an intermediate medium, may also represent communication between, or interaction of, two components. For those skilled in the art, the specific meanings of the above terms in the embodiments of the present disclosure should be understood based on the particular context.

In the drawings corresponding to the embodiments of the present disclosure, the thicknesses and areas of the layers are exaggerated for better understanding and ease of description. When a component (such as a layer, film, region, or substrate) is described as being "on" or "over" another component, the component may be positioned directly on the surface of the other component, or one or more additional components may be interposed therebetween. In contrast, when a component is described as being on the surface of another component, or when another component is described as being formed on or arranged on the surface of a component, this indicates that no additional component is present between the two. Furthermore, when a component is described as being "substantially" formed on another component, it means that the component is not formed over the entire surface (or front surface) of the other component, nor merely along a partial edge of the entire surface.

In the description of the embodiments of the present disclosure, when a component is described as "including" another component, it does not exclude the presence of other components unless otherwise specified, and additional components may also be included. Furthermore, when a component such as a layer, film, region, or plate is described as being "on" or "arranged on" another component, it may be directly on the other component (i.e., located on the surface of the other component with no intervening component), or one or more additional components may be interposed therebetween. In addition, when a layer, film, region, or plate is described as being directly on another component, or as being on the surface of another component, it indicates that no other component is interposed between them.

The terminology used in the description of the various embodiments set forth herein is intended solely to describe particular embodiments, and is not meant to limit the scope of the present disclosure. As used in the descriptions of the various embodiments and the claims, the term "the component" is intended to encompass the plural form as well, unless the context clearly indicates otherwise. The term "component" herein may refer to elements such as layers, films, regions, or plates.

The various embodiments of the present disclosure will be described in detail below with reference to the drawings. However, it should be understood by those skilled in the art that numerous technical details are presented herein solely for a clearer understanding of the disclosed embodiments. Even in the absence of such technical details, or with various changes and modifications based on the following embodiments, the technical solutions sought to be protected by the present disclosure can still be implemented.

A back contact solar cell is provided according to an embodiment of the present disclosure. The back contact solar cell according to the embodiment of the present disclosure will be described in detail below with reference to the drawings.

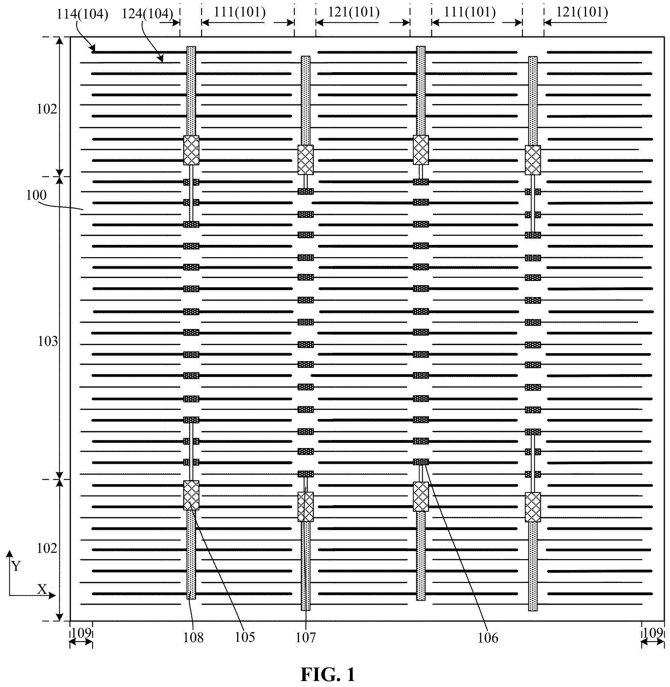

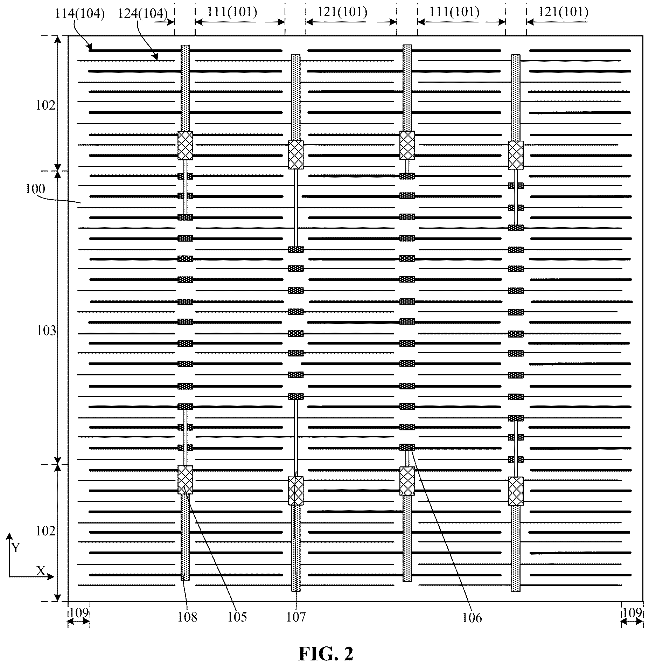

Referring to FIG. 1 or FIG. 2, a back contact solar cell includes: a cell substrate 100 divided into first soldering regions 111 and second soldering regions 121 alternately arranged along a first direction X, two opposite edge portions 102 along a second direction Y, and a central portion 103 located between the two edge portions 102; a plurality of first fingers 114 and second fingers 124 alternately arranged on the cell substrate 100 along the second direction Y, wherein the first fingers 114 are discontinuous in the second soldering regions 121, and the second fingers 124 are discontinuous in the first soldering regions 111; solder pads 105 located in portions of the soldering regions 101 corresponding to the edge portions 102, each solder pad 105 being in contact with at least two adjacent fingers 104 of the same polarity; a plurality of solder joints 106 located in portions of the soldering regions 101 corresponding to the central portion 103, each solder joint 106 being in contact with one finger 104, and M fingers 104 of the same polarity being arranged between adjacent solder pads 105 and solder joints 106 along the second direction Y, where M is an integer greater than or equal to zero; and a plurality of connection lines 107, each electrically connected to a solder pad 105 and at least one solder joint 106 located adjacent to the solder pad 105 along the second direction Y. Each finger 104 positioned between two opposite connection lines 107 along the second direction Y includes one solder joint 106. In particular, the soldering region 101 is the first soldering region 111, the fingers 104 of the same polarity are the first fingers 114; and/or the soldering region 101 is the second soldering region 121, the fingers 104 of the same polarity are the second fingers 124. It should be noted that the "cell substrate" herein refers to a silicon base and multiple thin-film layers on it, such as the passivation layer, doping layer, and antireflection layer. It should be further noted that the terms "soldering region", "edge portion", and "central portion" herein do not refer to actual physical structures on the cell substrate, but rather to regions artificially defined for the convenience of describing the locations of fingers/solder pads.

FIG. 1 is a first partial top view of a back contact solar cell according to an embodiment of the present disclosure. FIG. 2 is a second partial top view of the back contact solar cell according to an embodiment of the present disclosure. It should be noted that in FIG. 1 and FIG. 2, the first fingers 114 are illustrated by thicker solid lines, while the second fingers 124 are illustrated by thinner solid lines.

It should be noted that the solder pad 105 is located in the soldering region 101 at the edge portion 102, that is, the solder pad 105 lies where the soldering region 101 and the edge portion 102 coincide. The solder joint 106 is located in the soldering region 101 at the central portion 103, that is, the solder joint 106 lies where the soldering region 101 and the central portion 103 coincide. Thus, within the same soldering region 101, the solder pad 105 and the solder joint 106 are respectively positioned in the edge portion 102 and the central portion 103. The solder pad 105 may be regarded as the starting soldering position, i.e., the initial contact position, or the ending soldering position, i.e., the final contact position, of the tabbing ribbon during subsequent electrical connection with the back contact solar cell. In practical applications, when the tabbing ribbon makes contact with the solder pad 105 and the solder joint 106, the mechanical stress exerted by the tabbing ribbon on the solder pad 105, which serves as the starting or ending soldering position, is greater than that on the solder joint 106. Moreover, compared with the central portion 103, the edge portion 102 is more susceptible to external forces, making the solder pad 105 more likely to experience greater mechanical stress than the solder joint 106.

On this basis, a single solder pad 105 is in contact with at least two adjacent fingers 104 of the same polarity, while a single solder joint 106 is in contact with a single finger 104. In other words, the number of fingers 104 of the same polarity connected to a single solder pad 105 is greater than the number of fingers 104 of the same polarity connected to a single solder joint 106. On one hand, this configuration enhances the current collection performance of the solder pad 105, allowing current from more fingers 104 of the same polarity to be transferred to the solder pad 105 more rapidly, thereby forming a denser current collection network. This effectively shortens the transmission distance of photogenerated carriers and reduces the series resistance of the back contact solar cell. On the other hand, since the solder pad 105 serves as the starting or ending soldering position for a subsequent tabbing ribbon, the solder pad 105 that connects to more fingers 104 of the same polarity can be made larger in size. A larger solder pad not only reduces its own transmission resistance to better accommodate to the increased number of connected fingers, but also improves alignment precision and bonding strength between the tabbing ribbon and the solder pad 105. This helps prevent cold joints or de-soldering caused by excessive stress applied by the tabbing ribbon to the starting or ending soldering pad. In summary, these features contribute to improving the current collection efficiency of the back contact solar cell, and further enhance its photoelectric conversion efficiency.

The size of the solder pad 105 may be at least one of a diameter, a length, or a width of the solder pad 105.

In some cases, an orthographic projection of a single solder pad 105 on the cell substrate 100 may be greater than an orthographic projection of a single solder joint 106 on the cell substrate 100.

Furthermore, the solder pad 105 can be electrically connected, through the connection line 107, to at least one solder joint 106 located adjacent to the solder pad 105 along the second direction Y. It should be noted that, in general, the subsequent tabbing ribbon is in contact with the solder pad 105 serving as the starting or ending soldering position. For instance, as a greater amount of solder paste is typically required at these positions, the portion of the tabbing ribbon directly facing the solder pad 105 may be elevated due to solder paste accumulation. Consequently, the solder joint 106 located adjacent to the solder pad 105 is most affected by the solder paste of the tabbing ribbon. Since the tabbing ribbon is difficult to bend sharply within a short distance to contact the solder joint 106 near the pad 105, poor soldering or unsoldered conditions are likely to occur between the tabbing ribbon and the nearby solder joint 106. Moreover, as the height drop of the tabbing ribbon over a short distance is relatively large, detachment between the tabbing ribbon and the solder joint 106 adjacent to the solder pad 105 may easily occur afterward. Based on this, the connection line 107 directly electrically connects the solder joint 106, which is prone to poor, missing, or detached soldering with the subsequent tabbing ribbon, to the solder pad 105. Even if the solder joint 106 adjacent to the pad 105 has poor contact with the tabbing ribbon and fails to transfer current to the tabbing ribbon, the solder joint 106 can still transfer current directly to the solder pad 105 through the connection line 107, and then to the tabbing ribbon. In other words, the connection line 107 helps further ensure that the subsequent tabbing ribbon can collect current from all fingers 104 of the same polarity, e.g., all first fingers 114 or all second fingers 124, thereby further improving the photoelectric conversion efficiency of the back contact solar cell.

In addition, each finger 104 located between two connection lines 107 that are opposite to each other along the second direction Y is provided with one solder joint 106. It should be noted that the connection line 107 has a limited extension length along the second direction Y and does not extend over the entire length of the central portion 103 in the second direction Y. By providing one solder joint 106 on each finger 104 between the two connection lines 107, the current in any finger 104 located between the two connection lines 107 can be effectively collected by its corresponding solder joint 106. Furthermore, the solder joints 106 that are not in contact with the connection line 107 are located farther away from the solder pad 105 along the second direction Y. Even if the portion of the tabbing ribbon directly facing the solder pad 105 is elevated due to solder paste accumulation, the tabbing ribbon can still bend over a longer distance to be in contact with the solder joints 106 located farther from the solder pad 105, without exerting excessive tensile force on those solder joints 106 during soldering. As a result, poor soldering or detachment between the solder joints 106 located farther from the solder pad 105 and the tabbing ribbon can be effectively prevented, thereby ensuring the connection stability between such solder joints 106 and the tabbing ribbon.

It should be noted that the portion of the tabbing ribbon directly facing the solder pad 105 may be elevated due to the solder paste accumulation. Over a longer extension, the tabbing ribbon can bend downward under its own weight to be in contact with the solder joints 106 located farther from the solder pad 105.

It should be noted that M fingers 104 of the same polarity are provided between the solder pad 105 and the solder joint 106 that are adjacent along the second direction Y. For example, referring to FIG. 1, when M is 0, there are no fingers 104 of the same polarity between the solder pad 105 and the solder joint 106 that are adjacent along the second direction Y. Referring to FIG. 2, when M is greater than 0, fingers 104 of the same polarity are spaced between the solder pad 105 and the solder joint 106 that are adjacent along the second direction Y. Moreover, the connection line 107 contacts at least both the solder pad 105 and the solder joint 106 that are adjacent along the second direction Y. Regardless of whether fingers 104 of the same polarity are provided between the solder pad 105 and the solder joint 106 that are adjacent along the second direction Y, the current from the fingers 104 of the same polarity connected to the solder joint 106 can be collected by the connection line 107.

Furthermore, when fingers 104 of the same polarity are spaced between the solder pad 105 and the solder joint 106 that are adjacent along the second direction Y, on one hand, the connection line 107 can also contact the fingers 104 of the same polarity located between the solder pad 105 and the solder joint 106 that are adjacent, thereby collecting current from a greater number of fingers 104 of the same polarity. On the other hand, providing fingers 104 of the same polarity between the solder pad 105 and the solder joint 106 that are adjacent along the second direction Y increases the distance between the solder pad 105 and the solder joint 106 that are adjacent along the second direction Y. This extends the length over which the tabbing ribbon can bend from the elevated height at the solder pad 105 down to the height of the solder joint 106 adjacent to the solder pad 105. In other words, this reduces the bending height required per unit length along the second direction Y, thereby lowering the degree of bending the tabbing ribbon must undergo over per unit length. This facilitates bending the tabbing ribbon to reach the solder joint 106 adjacent to the solder pad 105, further reducing the soldering stress applied by the tabbing ribbon on the solder joint 106 adjacent to the solder pad 105, and effectively preventing conditions such as cold soldering or detachment between the solder joint 106 adjacent to the solder pad 105 and the tabbing ribbon, ensuring stable electrical connection.

In some cases, since the soldering region 101 includes two types, namely, a first soldering region 111 and a second soldering region 121, and the fingers 104 of the same polarity include two types, namely, a first finger 114 and a second finger 124, the solder pad 105 may also include two types, namely, a first solder pad and a second solder pad. Specifically, the first solder pad is located in the first soldering region 111 and is in contact with a portion of the first fingers 114, while the second pad is located in the second soldering region 121 and is in contact with a portion of the second fingers 124. In addition, the solder joint 106 may also include two types, namely, a first solder joint and a second solder joint. The first solder joint is located in the first soldering region 111 and is in contact with one first finger 114, and the second solder joint is located in the second soldering region 121 and is in contact with one second finger 124. It should be noted that, in the following description, the mentioned solder pad 105 may refer to at least one of the first solder pad or the second solder pad, and the solder joint 106 may refer to at least one of the first solder joint or the second solder joint.

The following provides a more detailed description of the embodiments of the present disclosure with reference to the drawings.

In some embodiments, referring to FIG. 1 or FIG. 2, the number of connection lines 107 electrically connected to the same solder pad 105 may be only one. This arrangement helps reduce the amount of raw material for manufacturing the connection line 107, thereby lowering the manufacturing cost of the back contact solar cell.

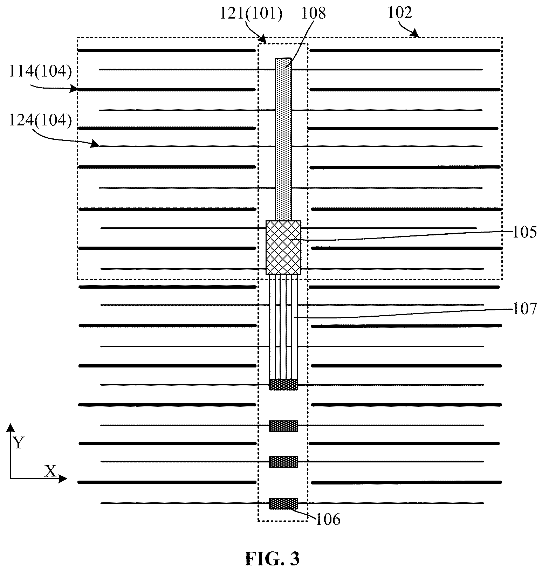

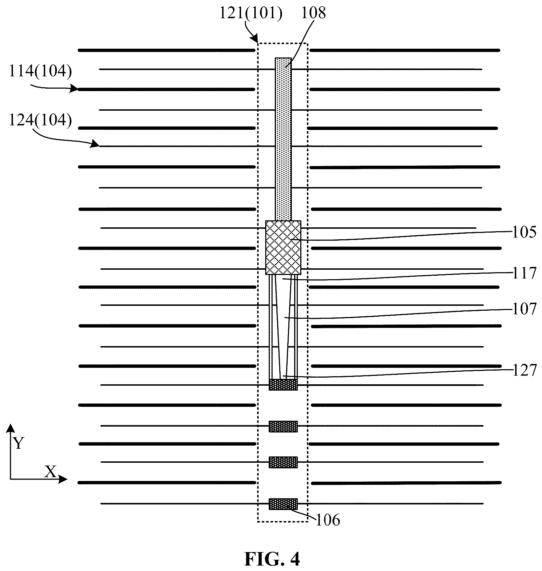

In other embodiments, referring to FIG. 3 or FIG. 4, the number of connection lines 107 electrically connected to the same solder pad 105 may be multiple, and each of these connection lines 107 is electrically connected to at least one solder joint 106 adjacent to the solder pad 105. In other words, multiple connection lines 107 connected to the same solder pad 105 can be regarded as a connection line set. Even if some of the connection lines 107 in a connection line set fail, for example, breakage occurs that prevents current from being transmitted from the solder joint 106 to the solder pad 105, the remaining connection lines 107 in the connection line set can still transmit current from the solder joint 106 to the solder pad 105. This further helps ensure a high current collection efficiency of the back contact solar cell.

FIG. 3 is a first partially enlarged top view of the back contact solar cell according to an embodiment of the present disclosure. FIG. 4 is a second partially enlarged top view of the back contact solar cell according to an embodiment of the present disclosure. It should be noted that in FIG. 3 and FIG. 4, the first finger 114 is illustrated by thick solid lines, while the second finger 124 is illustrated by thin solid lines.

It should be noted that in FIG. 3 and FIG. 4, the example shows that multiple connection lines 107 electrically connected to the same solder pad 105 are all connected to the solder joint 106 closest to the solder pad 105. In actual applications, the number of solder joints 106 contacted by different connection lines in the same connection line set can be the same or different. For example, in a connection line set, one connection line may contact to only one solder joint, while another connection line may contact to 2, 3, or 4 solder joints.

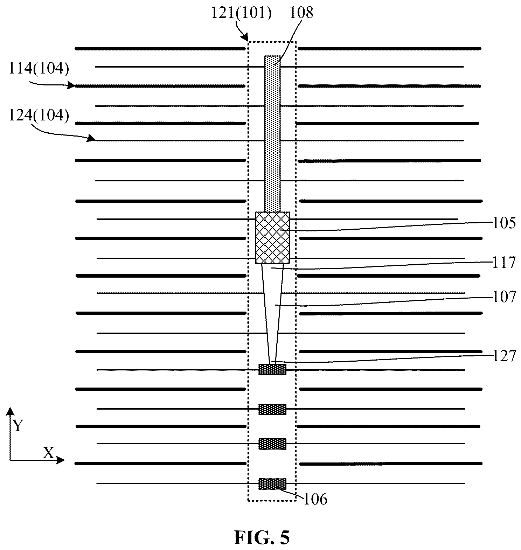

In some embodiments, referring to FIG. 4 or FIG. 5, where FIG. 5 is a third partially enlarged top view of the back contact solar cell according to an embodiment of the present disclosure, at least one connection line 107 may include a first end 117 adjacent to the solder pad 105 and a second end 127 adjacent to the solder joint 106. Along the first direction X, the width of the first end 117 is greater than the width of the second end 127.

It should be noted that when a subsequent tabbing ribbon contacts the solder pad 105 as a starting or ending soldering position, for example, where a relatively large amount of solder paste is applied, the portion adjacent to the solder pad 105 is more likely to contact molten solder paste compared to the solder joint 106. Therefore, in the connection line 107, the first end 117 adjacent to the solder pad 105 is more prone to breakage due to contact with molten solder paste than the second end 127 adjacent to the solder joint 106. For instance, after cooling, thermal expansion or contraction of the solder paste may cause the first end 117 to fracture. Based on this, the width of the first end 117 along the first direction X is greater than that of the second end 127. On one hand, the wider first end 117 reduces the risk of fracture caused by molten solder paste, thereby improving the structural stability of the connection line 107. On the other hand, when a finger 104 is provided between the solder pad 105 and the solder joint 106 that are adjacent along the second direction Y, the connection line 107 can also collect current from fingers 104 of the same polarity located between the solder pad 105 and the solder joint 106 that are adjacent. In the direction from the center region 103 (see FIG. 2) toward the edge portion 102 (see FIG. 2), the number of fingers 104 of the same polarity electrically connected to the connection line 107 gradually increases, and the current gathered by the connection line 107 correspondingly increases. A wider first end 117 helps reduce its own transmission resistance as well as increase the contact resistance between the first end 117 and the solder pad 105, thereby lowering the total transmission resistance along the path from the connection line 107 to the solder pad 105. This improves the current collection capability of the connection line 107 to accommodate to multiple fingers 104 of the same polarity, reducing the risk of overheating at the first end 117 due to current concentration, and enhancing the electrical performance and yield of the back contact solar cell. Additionally, when the subsequent tabbing ribbon contacts the solder pad 105 and the solder joint 106, the soldering stress exerted on the solder pad 105 as a starting or ending position is greater. A wider first end 117 increases the contact area with the solder pad 105, enhancing the connection strength between the first end 117 and the solder pad 105, and reducing the risk of detachment between the first end 117 and the solder pad 105 due to high soldering stress.

In addition, the connection line 107 is designed with varying widths along the first direction X at different positions along the second direction Y, which helps to reasonably reduce the amount of raw material for manufacturing the connection line 107, thereby lowering the manufacturing cost of the back contact solar cell.

In some cases, with reference to FIG. 4 or FIG. 5, among the solder pads 105 and the solder joints 106 located in the same soldering region 101, along the direction from the solder joint 106 toward the solder pad 105, that is, from the center region 103 toward the edge portion 102 (see FIG. 2), there is at least one connection line 107 has a width that gradually increases along the first direction X. As a result, the transmission resistance of the connection line 107 gradually decreases, facilitating the collection of current from more fingers 104 of the same polarity along its path, thereby enhancing the current collection capability of the connection line 107. This also helps to reduce the risk of overheating at the connection line 107 adjacent to the solder pad 105 due to current concentration, further improving the electrical performance and yield of the back contact solar cell.

It should be noted that multiple connection lines 107 are in a single back contact solar cell. The variation in width of any connection line 107 along the first direction X at different portions along the second direction Y can be tuned according to actual requirements. Along the first direction X, when the width of a first end 117 of any connection line 107 is greater than that of its second end 127, the structural stability of the connection line 107 can be improved, the current collection capability of the connection line 107 can be enhanced, and the connection strength between the first end 117 and the solder pad 105 can be increased, thereby reducing the risk of detachment between the first end 117 and the solder pad 105.

In some embodiments, referring to FIGS. 1 to 6, FIG. 6 is a fourth partially enlarged top view of a back contact solar cell according to an embodiment of the present disclosure. The back contact solar cell may further include a current collecting portion 108 disposed on a side of the solder pad 105 facing away from the solder joint 106 and located in the soldering region 101. A single current collecting portion 108 is in contact with multiple fingers 104 of the same polarity. In this way, multiple fingers 104 of a same polarity are located in the edge portion 102 and not in contact with the solder pad 105 can be connected to the current collecting portion 108, such that the current collecting portion 108 can collect currents from the multiple fingers 104 of the same polarity located in the edge portion 102 and not in contact with the pad 105, and eventually transmit the collected currents to the solder pad 105.

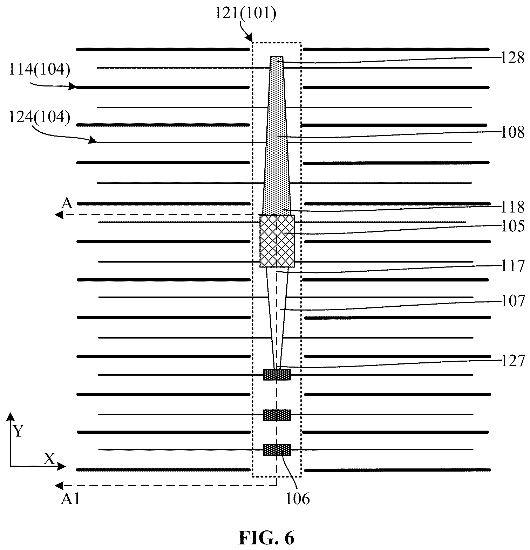

In some cases, referring to FIG. 6, at least one current collecting portion 108 may include a third end 118 adjacent to the solder pad 105 and a fourth end 128 located away from the solder pad 105. Along the first direction X, the width of the third end 118 is greater than that of the fourth end 128.

On one hand, when a tabbing ribbon is subsequently connected to the solder pad 105 serving as a starting or end soldering position, a relatively large amount of solder paste may be required during the soldering process, such that the portion adjacent to the solder pad 105 is more likely to contact molten solder paste. Accordingly, in the current collecting portion 108, compared with the fourth end 128 away from the solder pad 105, the third end 118 adjacent to the solder pad 105 is more prone to cracking due to contact with molten solder paste. Based on this, the design in which the third end 118 has a greater width than the fourth end 128 along the first direction X helps reduce the risk of cracking of the third end 118 caused by molten solder paste, thereby improving the structural stability of the current collecting portion 108.

On the other hand, compared with the central portion 103 (see FIG. 2), the edge portions 102 (see FIG. 2) are more susceptible to greater external forces. Based on this, the design in which the width of the third end 118 is greater than that of the fourth end 128 along the first direction X helps enlarge the contact area between the third end 118 and the solder pad 105, thereby increasing their bonding strength and reducing the risk of the third end 118 being detached from the solder pad 105 due to large external forces.

In another aspect, since the current collecting portion 108 can collect current from multiple fingers 104 of the same polarity located in the edge portion 102 and not connected to the solder pad 105, the number of fingers 104 of the same polarity electrically connected to the current collecting portion 108 gradually increases from the edge portion 102 toward the central portion 103. Accordingly, the current collected in the current collecting portion 108 gradually increases along this direction. The design in which the third end 118 has a greater width helps reduce the transmission resistance of the third end 118 itself as well as the contact resistance between the third end 118 and the solder pad 105. This collectively lowers the transmission resistance along the path from the current collecting portion 108 to the solder pad 105, thereby improving the current collection capability of the current collecting portion 108 to accommodate to multiple fingers 104 of the same polarity. As a result, this can reduce the risk of overheating at the third end 118 due to current concentration, thus enhancing the electrical performance and yield of the back contact solar cell.

In addition, the current collecting portion 108 that have varying widths along the first direction X at different positions along the second direction Y facilitates an optimized reduction in the amount of raw material required for manufacturing the current collecting portion 108, thereby lowering the manufacturing cost of the back contact solar cell.

In some cases, with reference to FIG. 6, the width of at least one current collecting portion 108 along the first direction X gradually increases in the direction from the edge portion 102 (see FIG. 2) toward the central portion 103 (see FIG. 2). In this way, the transmission resistance of the current collecting portion 108 itself gradually decreases, which facilitates the collection of current from an increasing number of fingers 104 of the same polarity along its path. This improves the current collection capability of the current collecting portion 108 and also helps to reduce the risk of overheating at the current collecting portion 108 adjacent to the solder pad 105 due to current accumulation, thereby enhancing the electrical performance and yield of the back contact solar cell.

It should be noted that multiple current collecting portions 108 are provided in a single back contact solar cell. The variation in width of any current collecting portion 108 along the first direction X at different positions along the second direction Y can be tuned according to practical requirements. By designing the width of the third end 118 of any current collecting portion 108 to be greater than the width of its fourth end 128 along the first direction X, the structural stability of the current collecting portion 108 can be improved, the current collection capability of the current collecting portion 108 can be enhanced, and the connection strength between the third end 118 and the solder pad 105 can be increased to reduce the risk of detachment between the third end 118 and the solder pad 105.

In some cases, with reference to FIGS. 1 to 6, the number of fingers 104 of the same polarity in contact with a single current collecting portion 108 may be greater than the number of fingers 104 of the same polarity in contact with a single solder pad 105. In this way, substantially equal spacing between any two adjacent fingers 104 of the same polarity along the second direction Y is advantageous to position the solder pad 105 in a portion of the edge portion 102 that is adjacent to the central portion 103. This avoids placing the solder pad 105 too close to the outer edge of the cell substrate 100, thereby preventing damage to the outer edge of the cell substrate 100 when the tabbing ribbon is subsequently soldered to the solder pad 105.

In some cases, with reference to FIGS. 1 to 6, the length of the connection line 107 along the second direction Y may be smaller than the length of the current collecting portion 108. It should be noted that along the second direction Y, the length of the connection line 107 is designed such that the bending degree required for the tabbing ribbon per unit length is relatively low, ensuring that at least one solder joint 106 in contact with the connection line 107 can be stably connected to the tabbing ribbon. Accordingly, the solder joints 106 that are not in contact with the connection line 107 can also be stably connected to the tabbing ribbon. This configuration facilitates stable current collection from each finger 104 located between two solder pads 105 that are aligned along the second direction Y, while minimizing the length of the connection line 107 as much as possible. As a result, the amount of raw materials for manufacturing the connection line 107 can be reduced, thereby lowering the manufacturing cost of the back contact solar cell.

In some cases, with reference to FIGS. 1 to 6, the cross-sectional area of the connection line 107 in a cross-section perpendicular to the second direction Y may be smaller than that of the current collecting portion 108.

It should be noted that the number of fingers 104 of the same polarity located between the solder pad 105 and the solder joint 106 adjacent along the second direction Y is relatively small, for example, zero. As a result, the number of fingers 104 of the same polarity from which the connection line 107 collects current is smaller than that of the fingers 104 of the same polarity located in the edge portion 102 from which the current collecting portion 108 collects current. Therefore, compared with the current density transmitted from the connection line 107 to the solder pad 105, the current density transmitted from the current collecting portion 108 to the solder pad 105 is higher. The cross-sectional area of the connection line 107 is smaller than that of the current collecting portion 108, and therefore the transmission resistance of the current collecting portion 108 can be further reduced, allowing the current collecting portion 108 to collect current from a larger number of fingers 104 of the same polarity along its path. This configuration enhances the current collection capability of the current collecting portion 108 and reduces the risk of overheating at the current collecting portion 108 adjacent to the solder pad 105 due to high current concentration, thereby improving the electrical performance and yield of the back contact solar cell.

In some embodiments, with reference to FIGS. 1 to 6, in a cross-section perpendicular to the second direction Y, the connection line 107 has a cross-sectional area defined as a first area. In a cross-section perpendicular to the first direction X, the finger 104 has a cross-sectional area defined as a second area. The first area may be greater than the second area. It should be noted that the connection line 107 is to transmit the current collected by the solder joint 106 from the finger 104 to the solder pad 105, and may additionally transmit part of the current from other fingers 104 of the same polarity to the solder pad 105. Therefore, compared with the finger 104, the connection line 107 needs to have a stronger current collection capability. Moreover, the connection line 107 must maintain good electrical contact with both the solder joint 106 and the solder pad 105. Based on this, the connection line 107 with a cross-sectional area greater than that of the finger 104 helps reduce the transmission resistance of the connection line 107, thereby improving its current collection efficiency. This also helps reduce the risk of overheating caused by excessive current concentration within the connection line 107 and reduces the risk of detachment between the connection line 107 and the solder joint 106 or the solder pad 105.

In some embodiments, with reference to FIGS. 1 to 6, the solder pad 105 may have an orthographic-projected area on the cell substrate 100 that is greater than the orthographic-projected area of the solder joint 106 on the cell substrate 100. Such a configuration not only helps reduce the transmission resistance of the solder pad 105 to improve its current collection capability, but also enhances the alignment accuracy and bonding strength between the solder pad 105 and a subsequently attached tabbing ribbon. This prevents conditions such as weak soldering or detachment that may occur when excessive pressure is applied by the tabbing ribbon to the solder pad 105 serving as a starting or ending soldering position, thereby improving the connection stability between the tabbing ribbon and the solder pad 105.

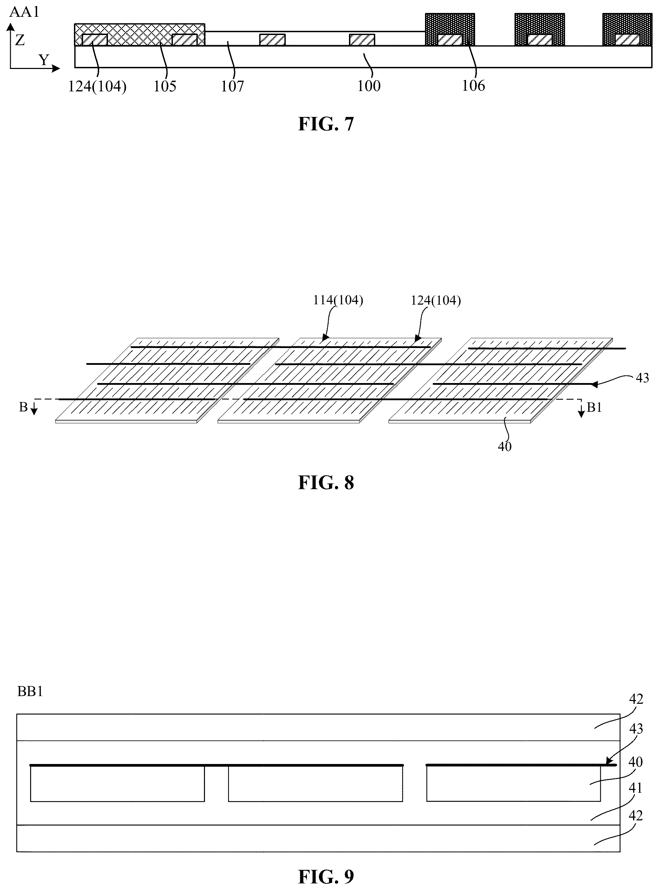

In some embodiments, with reference to FIG. 7, which is a partial cross-sectional schematic diagram of the back contact solar cell shown in FIG. 6 taken along a first section line AA1, the thickness of the solder pad 105 may be smaller than the thickness of the solder joint 106 along the third direction Z. The third direction Z represents the thickness direction of the cell substrate 100.

It should be noted that, in general, when a subsequent tabbing ribbon contacts a solder pad 105 serving as a starting or ending soldering position, such as in cases where a relatively large amount of solder paste is required, the portion of the tabbing ribbon directly facing the solder pad 105 may be elevated due to the accumulation of solder paste. Based on this, the solder pad 105 has a smaller thickness than the solder joint 106. When the portion of the tabbing ribbon facing the solder pad 105 and the portion of the tabbing ribbon facing the solder joint 106 are at the same height, a certain clearance can be reserved between the tabbing ribbon and the solder pad 105 as the tabbing ribbon contacts the solder joint 106 to accommodate the solder paste stacked on the solder pad 105. This helps effectively prevent poor contact between the tabbing ribbon and the solder pad 105 caused by the elevation from stacked solder paste, and further reduces the bending of the tabbing ribbon, for example, allowing the ribbon to be electrically connected with both the solder pad 105 and the solder joint 106 without bending downward. In addition, the solder pad 105 with a smaller thickness avoids excessively elevating the portion of the tabbing ribbon facing the solder pad 105 relative to the cell substrate 100 due to accumulated solder paste.

In some embodiments, with reference to FIG. 1 or FIG. 2, the number of solder joints 106 that are in contact with the connection line 107 on different soldering regions 101 may differ. It should be noted that, since different soldering regions 101 are subjected to different magnitudes of external pressure, the number of solder joints 106 that are in contact with the connection lines 107 is vary in different soldering regions 101. This can effectively reduce the risk that a solder joint 106 adjacent to the solder pad 105 may have poor contact with the tabbing ribbon, which could otherwise prevent current transmission to the tabbing ribbon, while reasonably controlling the length of the connection line 107 in the second direction Y. Accordingly, the amount of raw material for manufacturing the connection line 107 can be limited, thereby controlling the manufacturing cost of the back contact solar cell.

In some cases, with reference to FIG. 1 or FIG. 2, compared to a soldering region 101 subjected to relatively low external pressure, more solder joints 106 are designed to be electrically connected by connection line 107 in a soldering region 101 that is prone to higher external pressure. This helps reduce the risk of poor contact between solder joints 106 and the tabbing ribbon caused by greater external pressure, allowing connection line 107 to compensate for solder joints 106 that are more susceptible to pressure-induced failure and ensure proper current collection.

In some examples, with reference to FIG. 1 or FIG. 2, the cell substrate 100 may further include two edge portions 109 opposite along the first direction X. In this case, the number of solder joints 106 electrically connected to the connection line 107 in the soldering region 101 closest to the edge portion 109 is three, while the number of solder joints 106 electrically connected to connection line 107 in other soldering regions 101 is one.

In some embodiments, with reference to FIG. 2, the cell substrate 100 may further include two edge portions 109 opposite along the first direction X. In the same soldering region 101, the solder joint 106 closest to the solder pad 105 is defined as a target solder joint. The number of fingers 104 of the same polarity between the target solder joints and the solder pad 105 in the two soldering regions 101 closest to the edge portions 109 is a first number, while the number of fingers 104 of the same polarity between the target solder joints and the solder pad 105 in the other soldering regions 101 is a second number, the first number being less than the second number.

It should be noted that no solder joints 106 are provided on the fingers 104 of the same polarity between the target solder joints and the solder pad 105. Since the first number is smaller than the second number, more solder joints 106 are provided in the two soldering regions 101 closest to the edge portions 109 compared with the number of solder joints 106 in the other soldering regions 101. This configuration is advantageous in situations where the two soldering regions 101 closest to the edge portions 109 are more prone to larger external forces, as the greater number of solder joints 106 in these regions helps enhance the connection stability between the tabbing ribbon and the solder pads 105 as well as the solder joints 106 in the two soldering regions 101 closest to the edge portions 109. Further, reducing the number of solder joints 106 in the other soldering regions 101 helps lower the manufacturing cost of the back contact solar cell.

In some examples, with further reference to FIG. 2, there is no finger 104 between the target solder joints and the solder pad 105 in the two soldering regions 101 closest to the edge portions 109. Whereas there are three fingers 104 of the same polarity between the target solder joints and the solder pad 105 in the other soldering regions 101.

In summary, in the same soldering region 101, the solder pad 105 and the solder joint 106 are respectively located in the edge portion 102 and the central portion 103, and the solder pad 105 can be regarded as a starting or ending soldering position when subsequently a tabbing ribbon electrically contacts the back contact solar cell. On this basis, a single solder pad 105 contacts at least two adjacent fingers 104 of the same polarity, while a single solder joint 106 contacts a single finger 104. On one hand, this enhances the current collection performance of the solder pad 105, allowing the current from more fingers 104 of the same polarity to be transmitted to the solder pad 105 more rapidly, thereby establishing a denser current collection network, reducing the transmission distance of photogenerated carriers, and lowering the series resistance of the back contact solar cell. On the other hand, as a starting or ending soldering position for the subsequent tabbing ribbon, the solder pad 105 connecting more fingers 104 of the same polarity can have a larger size. This not only reduces the transmission resistance of the solder pad 105 to accommodate to more fingers 104 of the same polarity, but also improves the alignment accuracy and connection strength between the subsequent tabbing ribbon and the solder pad 105, preventing potential poor soldering or detachment caused by excessive pressure from the tabbing ribbon. Collectively, these design considerations help improve the current collection efficiency of the solder pad 105 and enhance the connection stability between the subsequent tabbing ribbon and the solder pad 105, which in turn contributes to an overall increase in the current collection efficiency and photoelectric conversion efficiency of the back contact solar cell.

Further, the solder pad 105 can be electrically connected to at least one solder joint 106 adjacent to the solder pad 105 along the second direction Y through the connection line 107. In other words, the connection line 107 can electrically connect the solder joints 106 adjacent to the solder pad 105 that are prone to poor contact, missed soldering, or detachment with the subsequent tabbing ribbon directly to the solder pad 105. Even if a solder joint 106 adjacent to the solder pad 105 fails to transmit current to the tabbing ribbon due to poor contact, this solder joint 106 can still transmit current to the solder pad 105 through the connection line 107 and then to the tabbing ribbon. Therefore, the connection line 107 further ensures that the subsequent tabbing ribbon can collect current from all the fingers of the same polarity, thereby improving the photoelectric conversion efficiency of the back contact solar cell.

A photovoltaic module is provided according to another embodiment of the present disclosure. The photovoltaic module is formed by connecting a plurality of the aforementioned back contact solar cells, or formed by connecting a plurality of back contact solar cells prepared by the aforementioned method. The following description refers to the drawings to illustrate the photovoltaic module. It should be noted that portions that are identical or corresponding to those in the previous embodiments will not be repeated herein.

Referring to FIGS. 8 and 9 together with FIGS. 1 to 7, the photovoltaic module includes: a solar cell string, formed by connecting a plurality of the aforementioned back-contact solar cells 40; an encapsulant 41, configured to cover a surface of the solar cell string; and a cover plate 42, configured to cover a surface of the encapsulant 41 that faces away from the solar cell string.

Here, FIG. 8 is a partial perspective view of the photovoltaic module according to an embodiment of the present disclosure. FIG. 9 is a partial cross-sectional view of the photovoltaic module along a second cross-section direction BB1 as shown in FIG. 8.

In some embodiments, the back contact solar cell 40 is a BC (back contact) cell, which includes, but is not limited to, IBC (interdigitated back contact) solar cells, HBC (heterojunction back contact) solar cells, TBC (TOPCon back contact) solar cells, or HPBC (hybrid passivated back contact) solar cells. Further, the back contact solar cells 40 can be electrically connected either as whole cells or as sliced cells to form multiple solar cell strings, and these strings can be electrically connected in series and/or parallel. The back contact solar cells 40 may be either whole cells or sliced cells, where a sliced cell refers to a cell obtained by cutting a whole cell through a cutting process.

In some embodiments, with reference to FIG. 8 or FIG. 9, multiple back contact solar cells 40 can be electrically connected through tabbing ribbons 43. FIGS. 8 and 9 merely illustrate one possible positional relationship between the back contact solar cells 40. In practical applications, the grid lines of adjacent back contact solar cells may be located on different sides, in which case the tabbing ribbon connects the different sides of two adjacent back contact solar cells.

In some embodiments, the encapsulant 41 includes a first encapsulation layer and a second encapsulation layer, where the first encapsulation layer covers either the front or back side of the back contact solar cell 40, and the second encapsulation layer covers the other side. Specifically, at least one of the first or second encapsulation layers may be an organic encapsulant film such as polyvinyl butyral (PVB) film, ethylene-vinyl acetate (EVA) film, polyolefin elastomer (POE) film, or polyethylene terephthalate (PET) film. Alternatively, at least one of the first or second encapsulation layers may be an EP film, EPE film, or PVP film. Here, the EP film refers to a co-extruded film formed by laminating EVA and POE films, the EPE film refers to a co-extruded film formed by sequentially laminating EVA, POE and EVA films, and the PVP film refers to a co-extruded film formed by laminating POE, EVA and POE films. The co-extrusion may include sequentially extruding one or more materials onto an already-formed film during the film processing, or laminating already-formed films of different types together.

In some cases, the first encapsulation layer and the second encapsulation layer may still have a boundary before lamination. However, after the lamination process to form the photovoltaic module, the distinction between the first and second encapsulation layers no longer exists, and the two layers form an integrated encapsulant 41.

In some embodiments, the cover plate 42 can be a glass plate, a plastic plate, or other light-transmitting cover plate. Specifically, the surface of the cover plate 42 facing the encapsulant 41 can be textured or include multiple protruding structures to increase the utilization of incident light. The cover plate 42 includes a first cover plate and a second cover plate, where the first cover plate faces the first encapsulation layer, and the second cover plate faces the second encapsulation layer.

In some scenarios, the surface of the back contact solar cell 40 includes multiple fingers arranged at intervals along the second direction. During the construction of a solar cell string using the back contact solar cells 40, the tabbing ribbons 43 electrically connect the multiple fingers on each of two adjacent back contact solar cells 40.

Those skilled in the art should understand that the above-described embodiments are specific examples of implementing the present disclosure. In practical applications, various changes in form and detail can be made without departing from the scope of the present disclosure. Any person skilled in the art may make modifications and variations within the scope of the present disclosure. Therefore, the protection scope of the embodiments of the present disclosure should be defined by the claims.

## Claims

1. A back contact solar cell (40), comprising:
a cell substrate (100) divided into soldering regions (101) arranged along a first direction (X);
fingers (104) arranged on the cell substrate (100) along a second direction (Y);
solder pads (105) arranged in the soldering regions (101) and in edge portion (102)s of the substrate, wherein a respective solder pad (105) of the solder pads (105) is in contact with at least two adjacent fingers (104) of a same polarity;
solder joints (106) arranged in the soldering regions (101) and in a central portion (103) of the substrate surrounded by the edge portion (102)s, wherein a respective solder joint (106) is in contact with a respective finger (104); and
connection lines (107), extending along the second direction (Y) for connecting the solder joints (106) to the solder pads (105).

2. The back contact solar cell (40) according to claim 1, wherein a subset of connection lines (107) is in contact with a respective solder pad (105) of the solder pads (105), each being in contact with at least one solder joint (106) adjacent to the respective solder pad (105).

3. The back contact solar cell (40) according to claim 1 or 2, wherein at least one connection line (107) comprises a first end (117) adjacent to the solder pad (105) and a second end (127) adjacent to the solder joint (106), and a width of the first end (117) is greater than a width of the second end (127) along the first direction (X).

4. The back contact solar cell (40) according to any one of claims 1 to 3, further comprising:
a current collecting portion (108), located on a side of a respective solder pad (105) of the solder pads (105) away from the central portion (103) and in a respective soldering region (101) of the soldering regions (101), wherein the current collecting portion (108) is in contact with a plurality of fingers (104) of the same polarity.

5. The back contact solar cell (40) according to claim 4, wherein the number of fingers (104) of the same polarity in contact with the current collecting portion (108) is greater than the number of fingers (104) of the same polarity in contact with the respective solder pad (105).

6. The back contact solar cell (40) according to claim 4, wherein at least one connection line (107) is shorter than the current collecting portion (108) along the second direction (Y).

7. The back contact solar cell (40) according to claim 4, wherein a cross section of at least one connection line (107) is smaller than a cross section of the current collecting portion (108) along a section perpendicular to the second direction (Y).

8. The back contact solar cell (40) according to any one of claims 1 to 7, wherein at least one connection line (107) has a first cross-sectional area along a section perpendicular to the second direction (Y), at least one finger (104) has a second cross-sectional area along a section perpendicular to the first direction (X), and the first cross-sectional area is greater than the second cross-sectional area.

9. The back contact solar cell (40) according to any one of claims 1 to 8, wherein an orthographic projection of a respective solder pad of the solder pads (105) on the cell substrate (100) is greater than an orthographic projection of a respective one of the solder joints (106) on the cell substrate (100).

10. The back contact solar cell (40) according to any one of claims 1 to 9, wherein a thickness of a respective one of the solder pads (105) is smaller than a thickness of a respective one of the solder joints (106) along a third direction (Z).

11. The back contact solar cell (40) according to claim 1, wherein the number of solder joints (106) in contact with the connection line (107) differs among different soldering regions (101).

12. The back contact solar cell (40) according to any one of claims 1 to 11, wherein only one connection line (107) is electrically connected to a respective one of the solder pads (105).

13. The back contact solar cell (40) according to any one of claims 1 to 12, wherein the back contact solar cell is an interdigitated back contact (IBC) solar cell, heterojunction back contact (HBC) solar cell, TOPCon back contact (TBC) solar cell, or hybrid passivated back contact (HPBC) solar cell.

14. A photovoltaic module, comprising:
a solar cell string, formed by connecting a plurality of back contact solar cells, at least one of the plurality of back contact solar cells being the back contact solar cell (40) according to any one of claims 1 to 13;
an encapsulant, configured to cover a surface of the solar cell string; and
a cover plate, configured to cover a surface of the encapsulant facing away from the solar cell string.

15. The photovoltaic module according to claim 14, wherein the plurality of back contact solar cells are electrically connected through tabbing ribbons (43).
